# EUROPEAN PATENT SPECIFICATION

(11) **EP 3 895 236 B1**
(45) Date of publication and mention of the grant of the patent: **13.08.2025**
(21) Application number: 19896067.6
(22) Date of filing: 02.12.2019
(51) Int. Cl.: H01M 4/139, H01M 4/04, B65H 18/10, B65H 23/26, B65H 23/28, H01M 10/052, C23C 14/56, C23C 16/54

(54) **FREE-SPAN COATING SYSTEMS AND METHODS**
FREISPANNBESCHICHTUNGSSYSTEME UND -VERFAHREN
SYSTÈMES ET PROCÉDÉS DE REVÊTEMENT À PORTÉE LIBRE

(30) Priority: 12.12.2018 US 201862778417 P
(43) Date of publication of application: 20.10.2021
(73) Proprietor: Elevated Materials Germany GmbH, 63755 Alzenau (DE)
(72) Inventor: ISHIKAWA, David Masayuki, Santa Clara, California 95054 (US); RANGASAMY, Ezhiylmurugan, Santa Clara, California 95054 (US); GOIHL, Thomas, Santa Clara, California 95054 (US); HERLE, Subramanya P., Santa Clara, California 95054 (US)
(74) Representative: Zimmermann & Partner Patentanwälte mbB
(86) International application number: PCT/US2019/063995
(87) International publication number: WO 2020/123174

(56) References cited:
- WO-A1-2007/112370
- WO-A1-2011/036078
- WO-A1-2017/131997
- WO-A1-2017/131997
- WO-A2-2009/029944
- JP-A- 2007 214 109
- KR-A- 20120 046 610
- US-A1- 2008 202 418
- US-A1- 2014 326 182
- US-A1- 2016 340 776

## Description

### BACKGROUND

### Field

Implementations described herein generally relate to continuous web processing systems and more specifically to continuous web processing systems for pre-lithiating lithium-ion battery substrates.

### Description of the Related Art

Rechargeable electrochemical storage systems are becoming increasingly significant in everyday life. High-capacity electrochemical energy storage devices, such as lithium-ion (Li-ion) batteries, are used in a growing number of applications, including portable electronics, medical, transportation, grid-connected large energy storage, renewable energy storage, and uninterruptible power supply (UPS).

Typically, lithium batteries do not contain any metallic lithium for safety reasons but instead use a graphitic material as the anode. However, the use of graphite, which can be charged up to the limit composition LiC₆, results in a much lower capacity, in comparison with the use of silicon-blended graphite. Currently, the industry is moving away from graphitic-based anodes to silicon-blended graphite to increase energy cell density. However, silicon blended graphite anodes suffer from first cycle irreversible capacity loss (IRC). Li-ion battery specific energy and energy density appreciably declines due to active lithium loss during the first cycle charge when approximately five to twenty percent of the lithium from the cathode is consumed by solid electrolyte interphase formation ("SEI") at the anode.

Anode pre-lithiation prior to the first cycle charge is a common strategy for compensating active lithium loss. Furthermore, pre-lithiation provides other performance and reliability advantages to Li-ion battery performance. For example, pre-lithiation can decrease Li-ion battery impedance thereby improving rate capability. In addition, for silicon-based anodes, pre-lithiation can mitigate silicon cracking and pulverization by pre-expanding the silicon to enhance anode mechanical stability.

Various anode pre-lithiation methods exist including chemical pre-lithiation, electrochemical pre-lithiation, pre-lithiation by direct contact to lithium metal, and stabilized lithium metal powder ("SLMP"). However, these various anode pre-lithiation methods have long reaction times and inherent safety risks, which are unsuitable for volume Li-ion battery manufacturing.
Document WO 2009/029944 A2 describes methods and devices for improved sputtering systems. A magnetron sputtering system with a plurality of sputtering chambers is provided. Chilled rollers are provided in an area outside the sputter chamber to reduce the temperature of the substrate before it enters another sputtering chamber.
Document WO 2007/112370 A1 describes systems and methods for atomic layer deposition (ALD). Reactive first and second precursor gases are introduced into respective first and second precursor zones, and an inert gas is introduced into an isolation zone. As the substrate transits through the first precursor zone a monolayer of the first precursor gas is adsorbed to the surface of the substrate, and on a subsequent transit of the substrate through the second precursor zone the second precursor gas reacts with the adsorbed first precursor at the surface of the substrate, to thereby deposit a thin film on the substrate.
Document WO 20177/036078 A1 describes a modular substrate processing system for processing a flexible substrate. A process module includes a substrate guiding means including a first substrate guiding device and a second substrate guiding device. Two deposition sources are arranged at opposing sides of an intermediate space. The deposition sources are oriented vertically and facing the front surface of the substrate.

Thus, there is a need for pre-lithiation apparatus and methods to replenish lithium in various electrode structures lost due to first cycle irreversible capacity loss.

### SUMMARY

The invention is set out in the appended set of claims.

Implementations described herein generally relate to continuous web processing systems and more specifically to continuous web processing systems for pre-lithiating Li-ion battery substrates. In one implementation, a modular processing system is provided. The system comprises a common transfer chamber body defining a transfer volume. The system further comprises a first vertical chamber body defining a first processing volume and positioned on the common transfer chamber body. The transfer volume is in fluid communication with the first processing volume. The system further comprises a second vertical chamber body defining a second processing volume and positioned on the common transfer chamber body. The transfer volume is in fluid communication with the second processing volume. The system further comprises a reel-to-reel system operable to transport a continuous flexible substrate having an electrode structure formed thereon. The continuous flexible substrate extends from the transfer volume, through the first processing volume, returning to the transfer volume, through the second processing volume, and returning to the transfer volume.

In another implementation, a modular processing system is provided. The processing system comprises a reel-to-reel system operable to transport a continuous flexible substrate having an electrode structure formed thereon. The reel-to-reel system comprises an unwinding reel, on which the continuous flexible substrate is wound prior to processing, and operable to unwind and release the continuous flexible substrate for processing. The reel-to-reel system further comprises a winding reel operable to receive the continuous flexible substrate following processing, and operable to wind the continuous flexible substrate thereon. The reel-to-reel system further comprises a plurality of auxiliary tension reels, located on a path between the unwinding reel and the winding reel operable to guide the continuous flexible substrate. The processing system further comprises a common transfer chamber body defining a transfer volume. The processing system further comprises a first vertical chamber body defining a first processing volume and positioned on the common transfer chamber body. The transfer volume is in fluid communication with the first processing volume. The processing system further comprises a second vertical chamber body defining a second processing volume and positioned on the common transfer body. The transfer volume is in fluid communication with the second processing volume. The continuous flexible substrate extends from the transfer volume, through the first processing volume, returning to the transfer volume, through the second processing volume, and returning to the transfer volume.

In yet another implementation, a method of forming a pre-lithiated electrode on a flexible substrate is provided. The method comprises transporting a continuous flexible substrate into a first processing region of a first vertical processing module. The continuous flexible substrate comprises an electrode structure. The method further comprises exposing the continuous flexible substrate to a free-span pre-lithiation process while transporting the continuous flexible substrate through the first processing region. The method further comprises transporting the continuous flexible substrate out of the first processing region through a common transfer volume and into a second processing region of a second vertical processing chamber. The method further comprises exposing the continuous flexible substrate to a free-span passivation process while transporting the continuous flexible substrate through the second processing region.

### BRIEF DESCRIPTION OF THE DRAWINGS

So that the manner in which the above-recited features of the present disclosure can be understood in detail, a more particular description of the implementations, briefly summarized above, may be had by reference to implementations, some of which are illustrated in the appended drawings.
FIG. 1A illustrates a cross-sectional view of one implementation of an energy storage device including a pre-lithiated electrode structure formed according to implementations described herein;
FIG. 1B illustrates a cross-sectional view of a dual-sided electrode structure that is pre-lithiated according to implementations described herein;
FIG. 2 illustrates a schematic side view of a modular substrate processing system according to one or more implementations of the present disclosure;
FIG. 3 illustrates a schematic side view of a vertical processing module that may be used in the modular processing system of FIG. 2; and
FIG. 4 illustrates a process flow chart summarizing one implementation of a processing sequence of pre-lithiation and passivation of an electrode structure according to one or more implementations of the present disclosure.

To facilitate understanding, identical reference numerals have been used, where possible, to designate identical elements that are common to the figures. It is contemplated that elements and features of one implementation may be beneficially incorporated in other implementations without further recitation.

### DETAILED DESCRIPTION

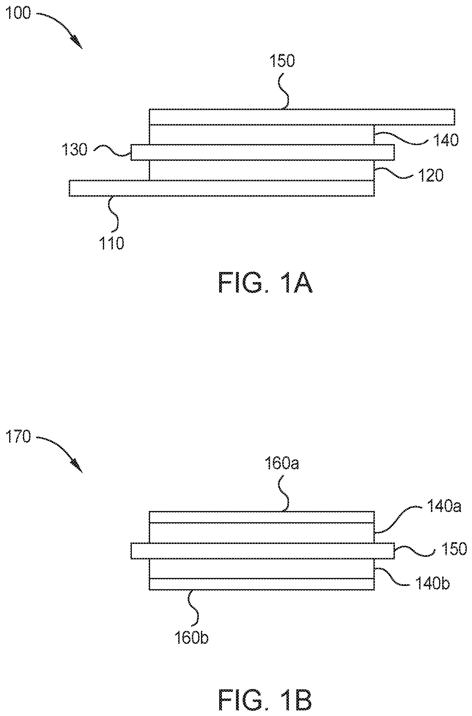

The following disclosure describes pre-lithiated electrodes, high performance electrochemical cells and batteries including the aforementioned pre-lithiated electrodes, apparatus and methods for fabricating the same. Certain details are set forth in the following description and in FIGS. 1A-4 to provide a thorough understanding of various implementations of the disclosure. Other details describing well-known structures and systems often associated with electrochemical cells and batteries are not set forth in the following disclosure to avoid unnecessarily obscuring the description of the various implementations.

Many of the details, dimensions, angles and other features shown in the Figures are merely illustrative of particular implementations.

Implementations described herein will be described below in reference to a roll-to-roll coating system. The apparatus description described herein is illustrative and should not be construed or interpreted as limiting the scope of the implementations described herein. It should also be understood that although described as a roll-to-roll process, the implementations described herein may be performed on discrete substrates.

Implementations described herein refer to a free-span coating system adapted for pre-lithiation of a flexible substrate such as a web for lithium-ion battery devices. In particular, the free-span coating system is adapted for continuous processing of a flexible substrate such as a web unwound from an unwinding module. The free-span coating system is configured in a modular design, for example, an appropriate number of process modules may be arranged adjacent to each other in a processing line, and the flexible substrate is inserted into the first process module and may be ejected from the last process module of the line. Furthermore, the entire free-span coating system may be re-configured if a change of individual processing operations is desired.

It is noted that while the particular substrate on which some implementations described herein may be practiced is not limited, it is particularly beneficial to practice the implementations on flexible substrates, including for example, web-based substrates, panels and discrete sheets. The substrate may also be in the form of a foil, a film, or a thin plate.

It is also noted here that a flexible substrate or web as used within the implementations described herein can typically be characterized in that it is bendable. The term "web" may be synonymously used to the term "strip" or the term "flexible substrate." For example, the web as described in implementations herein may be a foil.

It is further noted that in some implementations where the substrate is a vertically oriented substrate, the vertically oriented substrate may be angled relative to a vertical plane. For example, in some implementations, the substrate may be angled from between about 1 degree to about 20 degrees from the vertical plane. In some implementations where the substrate is a horizontally oriented substrate, the horizontally oriented substrate may be angled relative to a horizontal plane. For example, in some implementations, the substrate may be angled from between about 1 degree to about 20 degrees from the horizontal plane. As used herein, the term "vertical" is defined as a major surface or deposition surface of the flexible conductive substrate being perpendicular relative to the horizon. As used herein, the term "horizontal" is defined as a major surface or deposition surface of the flexible conductive substrate being parallel relative to the horizon.

It is also noted that free-span coating refers to a web-coating machine or process in which the web is not in contact with a surface during the actual film deposition part of the web coating process.

The web of substrate material may be continuously advanced through the line of interconnected process modules. In each process module, a portion of the pre-lithiation process may be performed. For example, if the lithium-ion device includes an anode structure, one or more processing modules may be adapted for pre-lithiating the anode structure and one or more succeeding process modules may be adapted for forming a protective coating or "passivation coating" over the pre-lithiated anode structure.

Li-ion batteries specific energy and energy density appreciably declines due to active lithium loss during the first cycle charge. Anode pre-lithiation prior to the first cycle charge is a common strategy for compensating for active lithium loss. Furthermore, pre-lithiation provides other performance and reliability advantages to Li-ion battery performance. For example, pre-lithiation can decrease Li-ion battery impedance thereby improving rate capability. In addition, for silicon (Si)-based anodes, pre-lithiation can mitigate silicon cracking and pulverization by pre-expanding the silicon to enhance anode mechanical stability.

Various anode pre-lithiation methods exist including chemical pre-lithiation, electrochemical pre-lithiation, pre-lithiation by direct contact to lithium metal, and stabilized lithium metal powder ("SLMP"). These existing pre-lithiation methods share common volume Li-ion battery manufacturing disadvantages, such as, long reaction times and inherent safety risks, which are unsuitable for volume lithium-ion battery manufacture.

SLMP, with up to 30% of the Li₂CO₃ powder shells remaining uncracked, incorporates inactive material into the cell mass, which reduces energy density of the Li-ion battery. Loose powder particles dislodged within the electrolyte while spreading SLMP, present inherent safety and reliability risks. Electrochemical pre-lithiation produces reactive material in ambient air, which can increase cell impedance due to nitrogen and oxygen contamination. Direct contact to lithium metal is a non-uniform and low yield process hindered by thin lithium metal foils sixty centimeters wide and discontinuous at twenty meters long or shorter. In addition, except for electrochemical pre-lithiation, Li-ion batteries manufactured using the aforementioned pre-lithiation methods may not perform as well as Li-ion batteries pre-lithiated with methods involving reactive lithium ions. Reactive lithium ions are more effective than lithium metal because the ions can penetrate and intercalate electrode pores to form lithium alloys throughout the graphite composite.

One pre-lithiation approach involving reactive lithium ions is vacuum thermal evaporation. Thermal evaporation involves heating lithium to produce a vapor composed of clusters of lithium atoms. The lithium cluster vapor mass flux and residual heat is controlled by the lithium-heating mode. Pools of molten lithium can be heated and controlled using electron beam, plasma, or resistive heating sources. As with electrochemical pre-lithiation, thermal evaporation delivers reactive lithium ions that can form alloys within the anode. Unlike electrochemical pre-lithiation, thermal evaporation is a vacuum process where reactive materials are isolated from oxygen and other species that could contaminate the anode. Further, regarding contamination minimization, vacuum processing at 10E-04 Torr or lower pressures has the ancillary benefit of dewatering residual moisture from the anode more effectively than oven heat treatments usually performed at higher pressures.

Thermal evaporation is believed to facilitate high quality and controllable pre-lithiation. However, strategies using thermal evaporation historically were cost prohibitive due to capital, energy, and maintenance costs. Commercial demand for advanced electrode active materials has since matured to the extent that vacuum thermal evaporation now has merit. Cost-competitive thermal evaporation requires an electrode application-specific web coating system design and operating method. The optimal pre-lithiation process for compensating active lithium loss involves reactive lithium ions alloying with the graphite, silicon, and/or other anode constituents to compensate for lithium consumed during SEI formation. The optimal production worthy manufacturing method involves web processing anode substrates over one meter wide and thousands of meters long at web speeds around forty meters per minute or faster.

Conventional web handling systems are not capable of double-sided coating let alone safe lithium thermal evaporation. The need therefore exists for a vacuum thermal evaporation pre-lithiation system and method that can meet volume lithium-ion battery manufacturing objectives for device performance, yield, throughput, and cost.

In some implementations of the present disclosure, a free-span coating system with cooling rollers to facilitate multiple pass lithium-ion battery pre-lithiation is provided. In some implementations, the free-span coating system has modular elements including at least one of deposition chambers, cooling turn-around chambers, and one or more load lock chambers. Therefore, each of the modular elements, can be arranged, rearranged, replaced, or maintained independently without affecting each other.

The free-span coating system is designed for producing either single-sided or double-sided coatings depending on the specific application. In some implementations, the free-span coating system is designed to facilitate deposition of multiple reactive materials at different temperatures. In some implementations, temperature measurement is accomplished using non-contact pyrometers and thermocouples to monitor the hot zone. In some implementations, quartz crystal monitors and residual gas analyzers are used to verify deposition rates.

In some implementations, the free-span coating system is used in spatial or temporal converting modes so that films of uniform thickness are produced by modulating the processing time or the processing length depending on the specific application. In some implementations, additional modular processing chambers are installed with similar process kits to process the web at faster speeds as an alternative to increasing temperature, which could damage the web. In some implementations, gas separation is accomplished by a common transfer chamber positioned beneath the deposition chambers. In some implementations, the web is cooled before exiting the deposition chamber and entering the common transfer chamber, which minimizes wrinkling of the web on the rollers of the transfer chamber.

In some implementations, cooling is accomplished by passing the web between two fluid cooled plates coupled via an appropriate coupling gas such as argon or helium. In some implementations, cooling is accomplished by the use of cooling plates, cooling drums, and/or cooling rollers.

In some implementations, the free-span coating system has features for efficient serviceability and maintenance. For example, the entire modular deposition chamber is removable from the transfer chamber for service, which facilitates safe lithium handling.

In some implementations, the free-span coating system is operable to simultaneously pre-lithiate both sides of a battery electrode. Alternative systems, which utilize single-pass double-sided coating around two cooling drums, are capital intensive, prone to web wrinkles and/or surface defects, low throughput, and harder to control pre-lithiation. Furthermore, some cooling drum designs suffer from parasitic deposition, which causes the heat transfer coefficient to drift. In some implementations, the free-span coating system operates without cooling drums and thus minimizes parasitic surface area.

In some implementations, pre-lithiation of coated electrodes using the systems described herein allows for (1) an increase in the lithium-ion battery energy density (kWh), and (2) reduction of the cathodic coating loading for the anode/cathode balancing, specifically the costly elements of cobalt and nickel. Thus, in some implementations, the free-span coating system described herein has a direct impact on the main figure of merit, cost/kWh, used in lithium-ion battery manufacturing. The free-span coating systems described herein are suitable for pre-lithiating any coated electrodes, either negative or positive. The free-span systems described herein provide battery manufacturers with great flexibility in cell balancing, for example, the ability to independently match reversible anode/cathode capacities and irreversible anode/cathode capacities.

In some implementations, a close couple gas diffuser is used to perform vertical free-span coating.

FIG. 1A illustrates a cross-sectional view of one implementation of an energy storage device 100 including a pre-lithiated electrode structure formed according to implementations described herein. The energy storage device 100 may be a lithium-ion energy storage device that uses solid electrolytes (e.g., a solid-state battery) as well as a lithium-ion energy storage device, which uses a liquid or polymer electrolyte. The energy storage device 100 has a positive current collector 110, a positive electrode structure 120, a separator 130, a negative electrode structure 140, and a negative current collector 150. At least one of the positive electrode structure 120 and the negative electrode structure 140 are pre-lithiated according to the implementations described herein. Note in FIG. 1A that the current collectors are shown to extend beyond the stack, although it is not necessary for the current collectors to extend beyond the stack, the portions extending beyond the stack may be used as tabs.

The current collectors 110, 150, on positive electrode structure 120 and negative electrode structure 140, respectively, can be identical or different electronic conductors. Examples of metals that the current collectors 110, 150 may be comprised of include aluminum (Al), copper (Cu), zinc (Zn), nickel (Ni), cobalt (Co), tin (Sn), silicon (Si), manganese (Mn), magnesium (Mg), alloys thereof, and combinations thereof. In some implementations, the current collectors 110, 150 are comprised of metal deposited on a polymer substrate.

The negative electrode structure 140 or anode may be any material compatible with the positive electrode structure 120. In some implementations, the negative electrode structure 140 is pre-lithiated according to implementations described herein. In some implementations, the negative electrode structure 140 has an energy capacity greater than or equal to 372 mAh/g, preferably ≥ 700 mAh/g, and most preferably ≥ 1000 mAh/g. In some implementations, the negative electrode structure 140 is constructed from a carbonaceous material (e.g., natural graphite or artificial graphite), silicon-containing graphite, silicon, nickel, copper, tin, indium, aluminum, silicon, oxides thereof, combinations thereof, or a mixture of a lithium metal and/or lithium alloy and materials such as carbon (e.g., coke, graphite), nickel, copper, tin, indium, aluminum, silicon, oxides thereof, or combinations thereof. Suitable examples of carbonaceous materials include natural and artificial graphite, partially graphitized or amorphous carbon, petroleum, coke, needle coke, and various mesophases. In some implementations, the negative electrode structure 140 comprises intercalation compounds containing lithium or insertion compounds containing lithium. In some implementations, the negative electrode structure 140 is a silicon graphite anode.

In some implementations, the material that forms the negative electrode structure 140 is in a disperse form such as powders, fibers, or flakes. In some implementations, the negative electrode structure 140 is manufactured by any method known in the art such as by preparing slurry from a carbonaceous powder and a binder agent, applying the slurry onto/into a current-collector, and drying. If employed, the binder agent can be chosen from such compounds including, but not limited, to, polyvinylidene fluoride (PVDF), ethylene-propylene diene monomer (EPDM), ethylene vinyl acetate copolymer (EVA), and combinations thereof.

The positive electrode structure 120 or cathode may be any material compatible with the anode and may include an intercalation compound, an insertion compound, or an electrochemically active polymer. In some implementations, the positive electrode structure 120 is pre-lithiated according to implementations described herein. Suitable intercalation materials include, for example, lithium-containing metal oxides, MoS₂, FeS₂, MnO₂, TiS₂, NbSe₃, LiCoO₂, LiNiO₂, LiMnO₂, LiMn₂O₄, V₆O₁₃ and V₂O₅. Suitable lithium-containing oxides may be layered, such as lithium cobalt oxide (LiCoO₂), or mixed metal oxides, such as LiNiₓCo₁₋₂ₓMnO₂, LiNiMnCoO₂ ("NMC"), LiNi_{0.5}Mn_{1.5}O₄**,** Li(Ni_{0.8}Co_{0.15}Al_{0.05})O₂, LiMn₂O₄, and doped lithium rich layered-layered materials, wherein x is zero or a non-zero number. Suitable phosphates may be iron olivine (LiFePO₄) and it is variants (such as LiFe₍₁₋ₓ₎MgₓPO₄), LiMoPO₄, LiCoPO₄, LiNiPO₄, Li₃V₂(PO₄)₃, LiVOPO₄, LiMP₂O₇, or LiFe_{1.5}P₂O₇, wherein x is zero or a non-zero number. Exemplary fluorophosphates may be LiVPO₄F, LiAlPO₄F, Li₅V(PO₄)₂F₂, Li₅Cr(PO₄)₂F₂, Li₂CoPO₄F, or Li₂NiPO₄F. Exemplary silicates may be Li₂FeSiO₄, Li₂MnSiO₄, or Li₂VOSiO₄. An exemplary non-lithium compound is Na₅V₂(PO₄)₂F₃.

In some implementations of a lithium-ion cell according to the present disclosure, lithium is contained in atomic layers of crystal structures of carbon graphite (LiC₆) at the negative electrode and lithium manganese oxide (LiMnO₄) or lithium cobalt oxide (LiCoO₂) at the positive electrode. Although in some implementations, the negative electrode may also include lithium-absorbing materials such as silicon, and/or tin. The cell, even though shown as a planar structure, may also be formed into a cylinder by reeling the stack of layers; furthermore, other cell configurations (e.g., prismatic cells, button cells) may be formed.

In one implementation, the separator 130 is a porous polymeric ion-conducting polymeric substrate. In one implementation, the porous polymeric substrate is a multi-layer polymeric substrate. In some implementations, the separator 130 includes any commercially available polymeric microporous membranes (e.g., single or multi-ply), for example, those products produced by Polypore (Celgard^{®} LLC., of Charlotte, North Carolina), Toray Tonen (Battery separator film (BSF)), SK Energy (lithium ion battery separator (LiBS), Evonik industries (SEPARION^{®} ceramic separator membrane), Asahi Kasei (Hipore^{™} polyolefin flat film membrane), and DuPont (Energain^{®}).

In some implementations, the electrolyte infused in cell components 120, 130, and 140 is comprised of a liquid/gel or a solid polymer and may be different in each. In some implementations, the electrolyte primarily includes a salt and a medium (e.g., in a liquid electrolyte, the medium may be referred to as a solvent; in a gel electrolyte, the medium may be a polymer matrix). The salt may be a lithium salt. The lithium salt may include, for example, LiPF₆, LiAsF₆, LiCF₃SO₃, LiN(CF₃SO₃)₃, LiBF₆, and LiClO₄, BETTE electrolyte (commercially available from 3M Corp. of Minneapolis, MN) and combinations thereof.

FIG. 1B illustrates a cross-sectional view of a dual-sided electrode structure 170 that is pre-lithiated according to implementations described herein. Although the dual-sided electrode structure 170 is depicted as a dual-sided electrode structure, it should be understood that the implementations described herein also apply to single-sided electrode structures. The dual-sided electrode structure 170 comprises the negative current collector 150 with a negative electrode structure 140a, 140b (collectively 140) formed on opposing sides of the negative current collector 150. The negative electrode structures 140a, 140b each have a passivation film 160a, 160b (collectively 160) formed respectively thereon for protecting the negative electrode structure 140 from contaminants, such as ambient oxidants. In some implementations, the passivation film 160 is permeable to at least one of lithium ions and lithium atoms. The passivation film 160 provides surface protection of the negative electrode structure 140, which allows for handling of the negative electrode structure 140 in a dry room and can contribute to stable SEI formation. Examples of materials that may be used to form the passivation film 160 include, but are not limited to, a lithium fluoride (LiF) film, a lithium carbonate (Li₂CO₃) film, a lithium oxide film, a lithium nitride (Li₃N) film, a lithium phosphate (Li₃PO₄) film, a lithium chloride (LiCl) film, lithium alkyl silanolate based film, alkyl siloxanes based film, a polyethylene (PE) film, a polypropylene (PP) film, a polystyrene (PS) film, or other polymer film that does not react with lithium, a poly(acrylic acid), ethylene vinyl acetate, or other polymer film that reacts with lithium, or combinations thereof. In some implementations, the passivation film 160 can be formed on the negative electrode structure 140 by vapor deposition methods, for example, chemical vapor deposition (CVD), atomic layer deposition (ALD), physical vapor deposition (PVD), such as thermal evaporation or sputtering. In some implementations, the passivation film 160 is deposited on the negative electrode structure 140 above the melting point of lithium to facilitate chemical bonding. In some implementations, the passivation film 160 can be deposited below the melting point of lithium and then the negative electrode structure 140 heat-treated up to or above the melting point of lithium.

In some implementations, the passivation film 160 may be a conformal coating or a discrete film, either having a thickness in the range of 1 nanometer to 2,000 nanometers (e.g., in the range of 10 nanometers to 600 nanometers; in the range of 50 nanometers to 100 nanometers; in the range of 50 nanometers to 200 nanometers; in the range of 100 nanometers to 150 nanometers). In some implementations, the passivation film 160 is a discrete film having a thickness in the range of 1 micron to 50 microns (e.g., in the range of 1 micron to 25 microns). Coating process parameters control the passivation film 160 protective surface properties including, for example, mechanical durability, hydrophobicity, and stickiness. Passivation film 160 properties can be optimized to minimize reaction with air for extending coated web usable shelf life, to facilitate battery substrate and device manufacturability including web handling, and to contribute to stable SEI formation during battery assembly and charging.

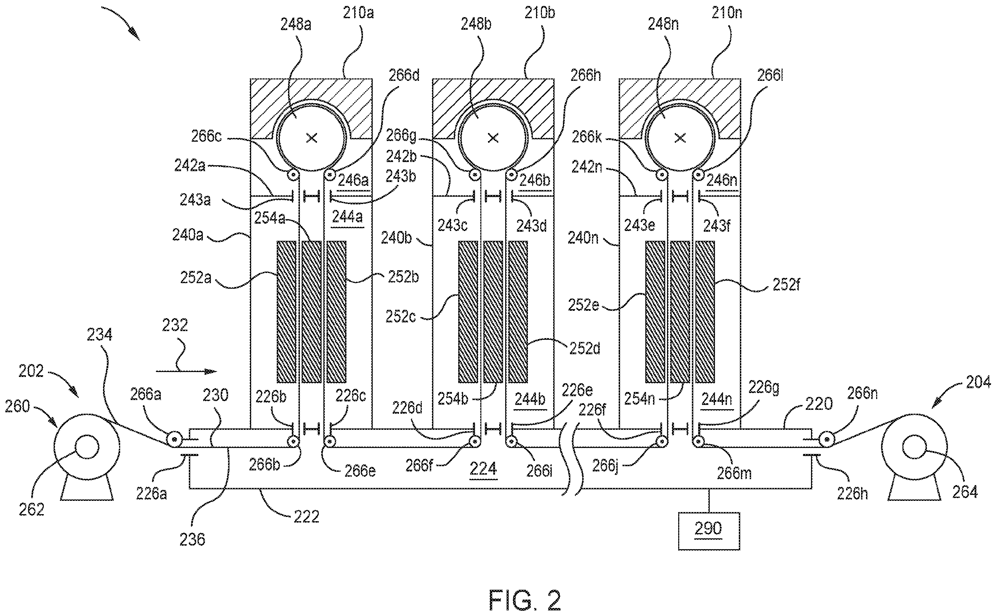

FIG. 2 depicts a schematic side view of a modular free-span coating system 200 according to one or more implementations of the present disclosure. The modular free-span coating system may be operable for either single-sided or double-sided processing of a flexible web. In some implementations, the modular free-span coating system 200 is operable for pre-lithiating anode structures or cathode structures formed on flexible substrates. The modular free-span coating system 200 is constituted as a roll-to-roll system including an upstream unwinding module 202, a common transfer chamber 220, a plurality of vertical processing modules 210a, 210b . . . 210n (collectively 210), and a downstream winding module 204. In some implementations, the vertical processing modules 210a, 210b . . . 210n are arranged in sequence, each configured to perform one processing operation to a continuous flexible substrate 230. Each vertical processing module 210 is operable to perform a free-span coating process on a continuous flexible substrate 230, which is vertically oriented within the vertical processing modules 210 during the free-span coating process.

As shown in FIG. 2, the vertical processing modules 210a, 210b . . . 210n are positioned on the common transfer chamber 220. The continuous flexible substrate 230 is shown to be inserted into the first vertical processing module 210a, and to be ejected, after appropriate processing operations or processing steps, from the last vertical processing module 210n. Thus, each vertical processing module 210a-210n has upstream components on the side where the substrate is inserted in the process module, and downstream components on the side where the substrate is ejected from that process module, such as the upstream unwinding module 202 and the downstream winding module 204. In some implementations, the upstream unwinding module 202 and the downstream winding module 204 are installed in separate chambers (e.g., a winding chamber and an unwinding chamber).

In some implementations, the continuous flexible substrate 230 is provided as a web, which is wound up on a roll and has a width in a range from 15 cm to 160 cm, and typically has a width of approximately 300 cm. In some implementations, the continuous flexible substrate 230 has a thickness in a range from 8 µm to 200 µm, for example, a thickness of approximately 50 µm. The continuous flexible substrate 230 has a front surface 234 and a back surface 236. In some implementations, the continuous flexible substrate 230 includes a flexible material having an electrode structure formed thereon. The electrode structure may be an anode structure or a cathode structure. For example, the flexible substrate may be the negative current collector 150 having the negative electrode structure 140 formed thereon as shown in FIG. 1B. In some implementations, only the front surface 234 of the flexible substrate has an electrode structure formed thereon. In some implementations, both the front surface 234 and the back surface 236 have electrode structures formed thereon.

The common transfer chamber 220 includes a common transfer chamber body 222 that defines a transfer volume 224. In some implementations, the common transfer chamber body 222 is fabricated from standard materials, such as aluminum, quartz, ceramic, or stainless steel. The common transfer chamber body 222 includes a plurality of through-holes 226a-226h (collectively 226) for accommodating the continuous flexible substrate 230. The plurality of through-holes 226 are typically aligned with corresponding through-holes in a vertical chamber body 240 of each corresponding vertical processing chamber 210. Each through-hole 226 in the common transfer chamber body 222 is sized to accommodate the continuous flexible substrate 230 while enabling differential pumping between a processing volume 244a, 244b . . . 244n (collectively 244) of each vertical processing module 210 and the transfer volume 224. The processing volume 244 is in fluid communication with the transfer volume 224. In some implementations, the processing volume 244 is a vacuum processing volume. In some implementations, an inert gas environment is maintained in the transfer volume 224. This inert gas environment of the transfer volume 224 isolates (e.g., provides gas separation) the processing volume 244, which may be a vacuum processing volume, of each vertical processing module 210 from the processing volume 244 of other vertical processing modules 210 positioned on the common transfer chamber 220. This isolation enables use of incompatible chemistries in different vertical processing modules 210. The inert gas flows between adjacent vertical processing modules and prevents the diffusion of precursor gaseous mixtures between the adjacent vertical processing modules. In some implementations, the common transfer chamber 220 is coupled to a pressure control system (not shown) which pumps down and vents the common transfer chamber 220 as needed to facilitate passing the continuous flexible substrate 230 between the vacuum environment of one vertical processing chamber and the substantially ambient (e.g., atmospheric) environment outside of the modular free-span coating system 200.

In some implementations, the vertical processing modules 210a-210n are stand-alone modular processing chambers wherein each modular processing chamber is structurally separated from the other modular processing chambers and the common transfer chamber 220. Therefore, each of the stand-alone vertical processing modules 210a-210n, can be arranged, rearranged, replaced, or maintained independently without affecting other vertical processing modules. Although three vertical processing modules 210a, 210b, and 210n are shown, it should be understood that any number of vertical processing modules may be included in the modular free-span coating system 200. For example, in some implementations, 2, 3, 4, 5, or more vertical processing modules 210 are included in the modular free-span coating system 200.

A lateral dimension of the modular free-span coating system 200, e.g., a dimension extending in a substrate transport direction 232 is reduced by arranging the processing chambers of individual vertical processing modules 210a-210n in a vertical orientation. Furthermore, according to implementations described herein, a horizontal movement of the continuous flexible substrate 230 from one module to the next module and, thereby, a horizontal web control can be realized. In addition, a vertical movement of the continuous flexible substrate 230 can be provided during pre-lithiation of the electrode structure on the continuous flexible substrate 230 by the arrangement of the modular system. Thereby, free graphite and parasitic particles from the deposition process that might be generated in the deposition regions are less likely to fall on the front face of the continuous flexible substrate 230, such that, for example damage to the deposited layers may occur due to flaking down of particles.

In some implementations of the present disclosure only two vertical processing modules 210a, 210b are presented, but additional vertical processing modules 210n may be included depending upon the targeted pre-lithiation process. For example, in some implementations where only two vertical processing modules 210 are present, the first vertical processing module 210a is operable to perform a thermal evaporation pre-lithiation process and the second vertical processing module 210b is operable to form a passivation film over the pre-lithiated electrode. In some implementations where more than two vertical processing modules 210 are present, multiple vertical processing modules 210 may be dedicated to the pre-lithiation process and/or the passivation process. In some implementations, additional vertical processing modules 210 are added and are operable to perform additional surface treatment processes, such as a corona surface treatment process, a pre-clean process, or a post clean process.

In some implementations, the vertical processing module 210 includes a vertical chamber body 240a, 240b . . . . 240n (collectively 240). In some implementations, the vertical chamber body 240 is fabricated from standard materials, such as aluminum, quartz, ceramic, or stainless steel. A partition plate 242a, 242b, . . . . 242n (collectively 242) extends across an interior volume defined by the vertical chamber body 240. The partition plate 242 separates the interior volume into the processing volume 244 for processing the continuous flexible substrate 230 and a turnaround volume 246a, 246b . . . . 246n (collectively 246) for reversing the direction of the continuous flexible substrate 230. The partition plate 242 includes a plurality of through holes 243a-243f (collectively 243) for accommodating the continuous flexible substrate 230. Each through-hole 243 in the partition plate 242 is sized to accommodate the continuous flexible substrate 230 while enabling differential pumping between the processing volume 244 and the turnaround volume 246.

It should be understood that although the processing volume 244 and the turnaround volume 246 are shown as sharing a common chamber body, in some implementations, the processing volume 244 and the turnaround volume 246 are defined by separate chamber bodies with the chamber body defining the turnaround volume 246 stacked upon the chamber body defining the processing volume 244. For example, in some implementations, the vertical processing module 210 includes a deposition chamber, which defines the processing volume 244 and a separate turnaround chamber, which defines the turnaround volume 246. The deposition chamber and the turnaround chamber are separate modular and stackable elements with the turnaround chamber stacked upon the deposition chamber.

The vertical processing modules 210a-210n may include any suitable structure, configuration, arrangement, and/or components that enable the modular free-span coating system 200 to pre-lithiate and/or passivate an electrode structure formed on the continuous flexible substrate 230 according to implementations of the present disclosure. For example, in some implementations the vertical processing modules 210a-210n include, but are not limited to, suitable deposition systems including thermal evaporation sources, vapor diffusers, power sources, individual pressure controls, deposition control systems, and temperature control components. In some implementations, the vertical processing modules 210a-210n are each provided with individual gas supplies. The vertical processing modules 210a-210n are typically separated from each other for providing a good gas separation. In some implementations, the vertical processing modules 210a-210n are separated from each other by the common transfer chamber 220. The modular free-span coating system 200 is not limited in the number of vertical processing modules 210a-210n. For example, in some implementations, the modular free-span coating system 200 may include two, three, four, five, or more vertical processing modules.

In some implementations, the vertical processing modules 210a-210n include one or more deposition units 252a-252f (collectively 252) operable to perform a surface modification treatment on one or more surfaces of the continuous flexible substrate 230. The one or more deposition units 252 are typically positioned in the processing volume 244 to perform free-span processing of the continuous flexible substrate 230. For example, with reference to FIG. 2, deposition unit 252a is positioned to process the continuous flexible substrate 230 while the continuous flexible substrate 230 is traveling between auxiliary tension reels 266b and auxiliary tension reel 266c. In some implementations, two deposition units 252a, 252b are arranged at opposing sides of the processing volume 244 with respect to the continuous flexible substrate 230, the deposition units 252a, 252b being oriented vertically and facing the front surface 234 of the continuous flexible substrate 230. In some implementations, the one or more deposition units 252 are positioned in the processing volume 244 parallel to the substrate transport direction 232 of the continuous flexible substrate 230. In some implementations, the one or more deposition units 252 are positioned such that a material to be deposited on the continuous flexible substrate 230 is delivered in a substantially perpendicular orientation relative to the substrate transport direction 232 of the continuous flexible substrate 230.

In some implementations, the one or more deposition units 252a-252f are vapor deposition sources. In some implementations, at least one of the one or more deposition units is a vertical diffuser operable for delivering evaporated lithium to the surface of the continuous flexible substrate 230. In some implementations, the one or more deposition units are each individually selected from the group of a CVD source, a PECVD source, and a PVD source such as a sputtering or thermal evaporation source. In some implementations, the one or more deposition units 252a-252f can independently include an evaporation source, a sputter source, such as, a magnetron sputter source, a DC sputter source, an AC sputter source, a pulsed sputter source, a radio frequency (RF) sputter source, or a middle frequency (MF) sputter source. The one or more deposition units can include an evaporation source. In some implementations, the evaporation source includes either a thermal evaporation source or an electron beam evaporation source. In some implementations, the evaporation source includes a lithium (Li) source. In some implementations, the evaporation source includes an alloy of two or more metals. The material to be deposited (e.g., lithium) can be provided in a crucible. In some implementations, the lithium is evaporated by thermal evaporation techniques or by electron beam evaporation techniques.

In some implementations, the vertical processing modules 210a-210n include one or more cooling sources 254a, 254b, . . . 254n (collectively 254). In some implementations, the cooling source 254 is a fluid cooled plate. In some implementations, the cooling source 254 is positioned in the processing volume 244 of the vertical processing module 210. In some implementations, as shown in FIG. 2, the cooling source 254 is positioned in between the dual deposition units 252. For example, in the first vertical processing module 210a, the cooling source 254a is positioned in between the deposition units 252a, 252b. Positioning the cooling source 254a in between the deposition units 252a, 252b allows the cooling source 254a to cool the continuous flexible substrate 230 both as the continuous flexible substrate 230 approaches the turnaround volume 246 and returns from the turnaround volume 246 approaching the transfer volume 224.

In some implementations, one or more of the vertical processing modules 210a-210n operable to perform deposition by other methods, such as, but not limited to, chemical vapor deposition, atomic laser deposition or pulsed laser deposition. In some implementations, one or more of the vertical processing modules are operable to perform a plasma treatment process, such as a plasma oxidation, or a plasma nitridation process.

In some implementations, the turnaround volume 246 includes an intermediate turnaround roller 248a, 248b, . . . 248n (collectively 248). The intermediate turnaround roller 248 diverts the direction of the continuous flexible substrate 230 from a vertical upward movement to a vertical downward movement. In some implementations, where the intermediate turnaround roller 248 faces the back surface 236 of the continuous flexible substrate 230, the intermediate turnaround roller may directly contact the back surface 236 of the continuous flexible substrate 230 and need not be designed as a gas cushion roller. In some implementations, the intermediate turnaround roller 248 is designed a gas cushion roller. In some implementations, the intermediate turnaround roller 248 is temperature-controlled. In some implementations, the intermediate turnaround roller 248 is heated. Heating of the intermediate turnaround roller 248 is believed to reduce wrinkles that may form in the continuous flexible substrate 230. In some implementations, the intermediate turnaround roller 248 is cooled. Cooling the intermediate turnaround roller 248 helps reduce the temperature of the continuous flexible substrate 230 after processing in the processing volume 244. Cooling the continuous flexible substrate 230 after processing is believed to reduce thermal damage to the continuous flexible substrate 230.

In some implementations, the modular free-span coating system 200 comprises a common transport architecture 260. The common transport architecture 260 may comprise any transfer mechanism capable of moving the continuous flexible substrate 230 through the processing volume 244 of each of the vertical processing modules 210a-210n. In some implementations, the common transport architecture 260 is a reel-to-reel system with a common winding reel 264 positioned in the downstream winding module 204, the intermediate turnaround roller 248 positioned in the turnaround volume 246, and an unwinding reel 262 positioned in the upstream unwinding module 202. In some implementations, the downstream winding module 204, the intermediate turnaround roller 248, and the unwinding reel 262 are individually heated or cooled depending upon the targeted process conditions. In some implementations, the downstream winding module 204, the intermediate turnaround roller 248, and the unwinding reel 262 are individually heated either using an internal heat source positioned within each reel or an external heat source. In some implementations, the downstream winding module 204, the intermediate turnaround roller 248, and the unwinding reel 262 are individually cooled using either an internal cooling source positioned within each reel or an external cooling source.

In some implementations, the common transport architecture 260 further includes one or more auxiliary tension reels 266a-266n (collectively 266) positioned between the unwinding reel 262, the intermediate turnaround roller 248, and the common winding reel 264. The auxiliary tension reels 266 are disposed on the path where the continuous flexible substrate 230 is conveyed between each vertical processing module 210a-210n, the unwinding reel 262, and the common winding reel 264, to allow a tensile force to the continuous flexible substrate 230. This tensile force prevents the continuous flexible substrate 230 from sagging down as well as to change the movement direction of the continuous flexible substrate 230. Accordingly, even though the continuous flexible substrate 230 is moved along a continuously long path, a certain movement rate is constantly maintained. In some implementations, any of the auxiliary tension reels 266 may be replace with gas cushion rollers. For implementations having discrete processing regions, modules, or chambers, the common transport architecture may be a reel-to-reel system where each vertical processing module or processing volume has an individual take-up-reel and feed reel and one or more optional intermediate transfer reels positioned between the take-up reel and the feed reel.

The transport speed of the continuous flexible substrate 230 through the modular free-span coating system 200, and through the individual vertical processing modules 210a-210n, is based on the number of vertical processing modules 210a-210n. In some implementations, a transport speed, which is used to move the continuous flexible substrate 230 through the vertical processing modules 210a-210n, is in a range from 0.1 m/min to 2.5 m/min, and typically amounts to 0.6 m/min.

In operation, the continuous flexible substrate 230 is conveyed from the upstream unwinding module 202 and passes through the through-hole 226a, advancing into the common transfer chamber 220. The continuous flexible substrate 230 is then moved vertically upward through the through-hole 226b so that the continuous flexible substrate 230 advances into the processing volume 244a of the first vertical processing module 210a. In the processing volume 244a, the continuous flexible substrate 230 travels in between the deposition unit 252a and the cooling source 254a where the continuous flexible substrate 230 is exposed to a free-span surface modification process such as a free-span pre-lithiation process. The continuous flexible substrate 230 is moved vertically upward through through-hole 243a, advancing into the turnaround volume 246 of the first vertical processing module 210a around the intermediate turnaround roller 248 where the continuous flexible substrate 230 is diverted to move vertically downward. The continuous flexible substrate 230 is moved vertically downward through the through-hole 243b returning to the processing volume 244a. In the processing volume 244a, the continuous flexible substrate 230 travels in between the deposition unit 252b and the cooling source 254a where the continuous flexible substrate 230 is exposed to an additional free-span surface modification process such as an additional free-span pre-lithiation process or a free-span passivation process. The continuous flexible substrate 230 is moved vertically downward through the through-hole 226c into the common transfer chamber 220. The continuous flexible substrate 230 then travels in a horizontal direction through the common transfer chamber 220 until the continuous flexible substrate 230 is diverted vertically upward through the through-hole 226d so that the continuous flexible substrate 230 advances into the processing volume 244b of the second vertical processing module 210b. In the processing volume 244b, the continuous flexible substrate 230 is exposed to a free-span surface modification process such as a free-span passivation process. The continuous flexible substrate 230 is moved vertically upward through through-hole 243c, advancing into the turnaround volume 246b of the second vertical processing module 210b around the intermediate turnaround roller 248b where the continuous flexible substrate 230 is diverted to move vertically downward. The continuous flexible substrate 230 is moved vertically downward through the through-hole 243d returning to the processing volume 244b where the continuous flexible substrate 230 is exposed to an additional free-span surface modification process such as a free-span passivation process. The continuous flexible substrate 230 is moved vertically downward through through-hole 226e returning to the common transfer chamber 220. In some implementations, the flexible substrate is subject to additional processing in additional vertical processing modules, for example, vertical processing module 210n.

Generally, the modular free-span coating system 200 includes a system controller 290 configured to control the automated aspects of the modular free-span coating system 200. The system controller 290 facilitates the control and automation of the overall modular free-span coating system 200 and may include a central processing unit (CPU) (not shown), memory (not shown), and support circuits (or I/O) (not shown). Software instructions and data can be coded and stored within the memory for instructing the CPU. A program (or computer instructions) readable by the system controller 290 determines which tasks are performable on a substrate. Preferably, the program is software readable by the system controller 290, which includes code to generate and store at least substrate positional information, the sequence of movement of the various controlled components, and any combination thereof.

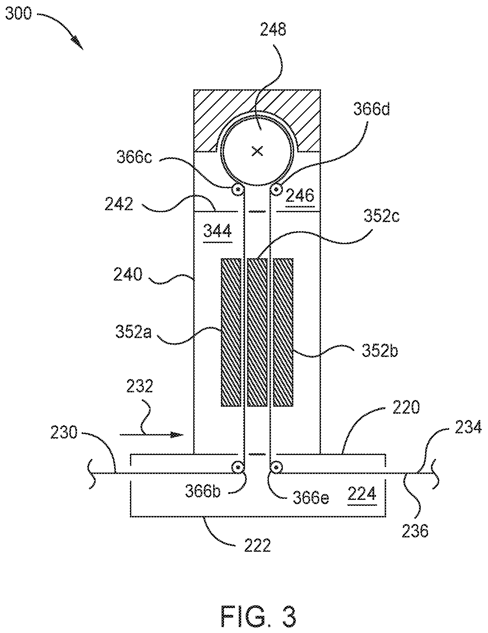

FIG. 3 depicts a schematic side view of a vertical processing module 300 that may be use in the modular free-span coating system 200 of FIG. 2. The vertical processing module 300 is operable to perform a double-sided surface modification process such as a double-sided free-span pre-lithiation process and/or a double-sided free-span passivation process. During the double-sided free-span pre-lithiation process opposing sides (e.g., the front surface 234 and the back surface 236) of the continuous flexible substrate 230 are simultaneously exposed to a free-span pre-lithiation process or a free-span passivation process. The vertical processing module 300 is similar to the vertical processing module 210 except that the vertical processing module 300 has three deposition units 352a-352c (collectively 352). The one or more deposition units 352 are typically positioned in the processing volume 344 to perform free-span processing of the continuous flexible substrate 230. For example, with reference to FIG. 3, deposition unit 352a is positioned to process the continuous flexible substrate 230 while the continuous flexible substrate 230 is traveling between auxiliary tension reels 366b and auxiliary tension reel 366c. Deposition unit 352b is positioned to process the continuous flexible substrate 230 while the continuous flexible substrate 230 is traveling between auxiliary tension reels 366d and auxiliary tension reel 366e. Deposition units 352a and 352b are positioned to process the front surface 234 of the continuous flexible substrate 230. Deposition unit 352c is positioned in between deposition units 352a and 352b and operable to process the back surface 236 of the continuous flexible substrate 230. In some implementations, the deposition units 352a-352c are configured similarly to the deposition unit 252.

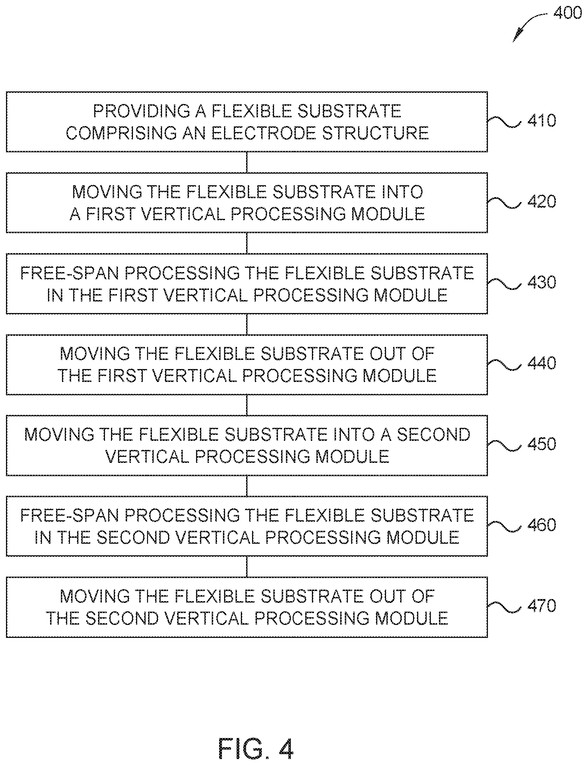

FIG. 4 illustrates a process flow chart summarizing one implementation of a processing sequence 400 of pre-lithiation and passivation of an electrode structure according to one or more implementations of the present disclosure. The processing sequence 400 may be used to pre-lithiate a single-sided electrode structure, for example, the electrode structure depicted in FIG. 1A, or a dual-sided electrode structure, for example, the electrode structure depicted in FIG. 1B. The processing sequence 400 may be performed using, for example, the modular free-span coating system 200 depicted in FIG. 2.

The processing sequence 400 begins at operation 410 by providing a flexible substrate comprising an electrode structure. In some implementations, the flexible substrate is continuous flexible substrate 230, which includes a negative electrode (anode electrode), for example, the negative electrode structure 140 formed on the negative current collector 150, or a positive electrode (cathode electrode), for example, the positive electrode structure 120 formed on the positive current collector 110 as depicted in FIG. 1A. In some implementations, the continuous flexible substrate 230 includes a dual-sided electrode structure, such as the dual-sided electrode structure 170, which comprises the negative current collector 150 with a negative electrode structure 140a, 140b (collectively 140) formed on opposing sides of the negative current collector 150 as shown in FIG. 1B.

At operation 420, the flexible substrate is moved into a first vertical processing module. Referring to FIG. 2, in some implementations, the continuous flexible substrate 230 is conveyed from the upstream unwinding module 202 and passes through the through-hole 226a, advancing into the common transfer chamber 220. The continuous flexible substrate 230 is then moved vertically upward through the through-hole 226b so that the continuous flexible substrate 230 advances into the processing volume 244a of the first vertical processing module 210a.

At operation 430, the flexible substrate is processed in the first vertical processing module. In some implementations, the process is a free-span pre-lithiation process that involves reactive lithium ions condensing on the continuous flexible substrate 230 and intercalating along grain boundaries in the negative electrode structure 140. Referring to FIG. 2, in some implementations, in the processing volume 244a, the continuous flexible substrate 230 travels in between the deposition unit 252a and the cooling source 254a where the continuous flexible substrate 230 is exposed to a free-span surface modification process such as a free-span pre-lithiation process. In some implementations, the deposition unit 252a is a vapor diffuser. The free-span pre-lithiation process includes delivering vaporized lithium via the deposition unit 252a toward the continuous flexible substrate 230. The vaporized lithium pre-lithiates the electrode structure by condensing on the electrode structure of the continuous flexible substrate 230. In some implementations, the degree of pre-lithiation is controlled by adjusting the temperature and concentration of reactive lithium ions emitted by the deposition unit 252. The degree of pre-lithiation is also controlled by the heat transfer from the continuous flexible substrate 230 to cooling sources 254 and transport speed. It is noted that lithium can continue to intercalate along grain boundaries in the negative electrode after the coating process is complete. Therefore, in some implementations, the free-span pre-lithiation process is utilized with subsequent material aging and other treatments to produce material having a controlled degree of pre-lithiation.

After the first pre-lithiation process, the continuous flexible substrate 230 is moved vertically upward through through-hole 243a, advancing into the turnaround volume 246 of the first vertical processing module 210a around the intermediate turnaround roller 248a where the continuous flexible substrate 230 is diverted to move vertically downward. In some implementations where the intermediate turnaround roller 248a is temperature-controlled, the continuous flexible substrate 230 is cooled or heated by the intermediate turnaround roller 248a. The continuous flexible substrate 230 is moved vertically downward through the through-hole 243b returning to the processing volume 244a. In the processing volume 244a, the continuous flexible substrate 230 travels in between the deposition unit 252b and the cooling source 254a where the continuous flexible substrate 230 is exposed to an additional free-span pre-lithiation process to provide additional lithium to the electrode structure of the continuous flexible substrate 230.

At operation 440, the continuous flexible substrate 230 is moved out of the first vertical processing module 210a. The continuous flexible substrate 230 is moved vertically downward through the through-hole 226c into the common transfer chamber 220. The continuous flexible substrate 230 then travels in a horizontal direction through the common transfer chamber 220 until the continuous flexible substrate 230 is diverted vertically upward through the through-hole 226d so that the continuous flexible substrate 230 advances into the processing volume 244b of the second vertical processing module 210b at operation 450.

At operation 460, the continuous flexible substrate 230 is processed in the processing volume 244b of the second vertical processing module 210b. In the processing volume 244b of the second vertical processing module 210b, the continuous flexible substrate 230 is exposed to a free-span surface modification process such as a free-span passivation process. In some implementations, the free-span passivation process forms a passivation film, such as the passivation film 160, on the pre-lithiated electrode structure. In some implementations, the passivation film can be formed on the electrode structure by vapor deposition methods, for example, chemical vapor deposition (CVD), aerosol assisted chemical vapor deposition (AACVD), atomic layer deposition (ALD), electrospray deposition (ESD), or physical vapor deposition (PVD), such as evaporation or sputtering.

At operation 470, the continuous flexible substrate 230 is moved out of the second vertical processing module 210b. The continuous flexible substrate 230 is moved vertically downward through the through-hole 226e into the common transfer chamber 220. In one implementation, where the continuous flexible substrate 230 is subjected to additional processing, the continuous flexible substrate 230 then travels in a horizontal direction through the common transfer chamber 220 until the continuous flexible substrate 230 is diverted vertically upward through the through-hole 226f so that the continuous flexible substrate 230 advances into the processing volume 244n of the vertical processing module 210n. In another implementation, where processing of the continuous flexible substrate 230 is complete, the continuous flexible substrate 230 exits the common transfer chamber 220 via through-hole 226h. After exiting the common transfer chamber 220, the continuous flexible substrate 230 may be wound onto the winding reel 264.

In some implementations, the passivation film 160 can be formed using gaseous or liquid precursors that are either inert or reactive with lithium above or below the lithium melting point. For example, the passivation film 160 can be formed by introducing anhydrous carbon dioxide in between the deposition unit 252 in the processing volume 244b of the second vertical processing module 210b to form a protective layer of lithium carbonate (Li₂CO₃) on pre-lithiated surfaces formed in the processing volume 244a of the first vertical processing module 210a. The operating temperature of the deposition unit 252 and latent heat of the continuous flexible substrate 230 affect the lithium carbonate pinhole-free quality and total thickness. In some implementations, phosphoric acid is used instead of carbon dioxide to form a protective layer of lithium phosphate (Li₃PO₄) which is more moisture resistant than lithium carbonate and therefore more effective at reducing coated web air reactivity for a longer period. In some implementations, where it is desirable to avoid heating the pre-lithiated negative electrode structure 140 during passivation processing, chlorosilane vapors are used to produce a thin layer of lithium chloride (LiCl) and either lithium alkyl silanolate derivatives or alkyl siloxanes to produce a passivation film, for example, passivation film 160 that is more heat stable than lithium carbonate or lithium phosphate. In some implementations, the passivation film 160 is comprised of two or more laminar films such as a lithium carbonate film that minimizes air reactivity and an organic layer such as wax, for example, a polyethylene wax such as Luwax^{®} that improves web durability and facilitates battery assembly. In some implementations, the passivation film 160 is comprised of one or more layers of polyethylene oxide, ethylene vinyl acetate, or other polymer that has low solubility in N-methyl-2-pyrrolidone (NMP) to improve stability and storage life. The common transfer chamber 220 provides spatial isolation between the processing volume 244a and the processing volume 244b prevents reactive gas or vapor precursors used in the passivation process from migrating upstream and contaminating the pre-lithiation process.

The continuous flexible substrate 230 is moved vertically upward through through-hole 243c, advancing into the turnaround volume 246b of the second vertical processing module 210b around the intermediate turnaround roller 248b where the continuous flexible substrate 230 is diverted to move vertically downward. The continuous flexible substrate 230 is moved vertically downward through the through-hole 243d returning to the processing volume 244b where the continuous flexible substrate 230 is exposed to an additional free-span surface modification process such as a free-span passivation process. The continuous flexible substrate 230 is moved vertically downward through through-hole 226e returning to the common transfer chamber 220.

In some implementations, the continuous flexible substrate 230 is subject to additional processing in additional vertical processing modules, for example, vertical processing module 210n. In some implementations, additional processing may provide for deposition of a separator, an electrolyte soluble binder, or in some implementations, additional chambers may provide for formation of a positive electrode structure. In some implementations, additional chambers provide for cutting of the negative electrode. The passivation film may be removed after cutting of the negative electrode.

In summary, some of the benefits of the present disclosure include the efficient integration of pre-lithiation and passivation into a modular free-span processing system. Currently, lithium metal deposition is performed in a dry room or an argon gas atmosphere. Due to the volatility of lithium metal, subsequent processing steps must also be performed in an argon gas atmosphere. Performance of subsequent processing steps in an argon gas atmosphere would require retrofitting of current manufacturing tools. It has been found by the inventors that coating the lithium metal with a protective film prior to subsequent processing, allows subsequent processing to be performed either under vacuum or at atmosphere. The protective film eliminates the need to perform additional processing operations in an inert gas atmosphere reducing the complexity of tools. The protective film also allows for the transportation, storage, or both of the negative electrode with the lithium metal film formed thereon. Additionally, vertically oriented pre-lithiation and passivation of an electrode structure allows for modulation of either processing time or processing length while reducing the footprint of the system.

In addition, free-span coating eliminates contact between the web and cooling drum near the vapor source high thermal load. Removing web handling requirements from the deposition in volume prevents winding defects such as wrinkles. Free-span coating also facilitates high web speed (e.g., greater than 1 meter per minute, up to 40 meters per minute) at low level cost of equipment. The free-span coating system is designed to minimize wrinkles. In some implementations, the coating system has multiple chambers operating at different temperatures to maximize coating thickness and uniformity without damaging the heat sensitive substrate. In some implementations, the coating system can control the coating rate by optimizing temperatures, processing length, and web speed. In some implementations, the coating system has a high lithium utilization rate due to the minimization of parasitic surfaces.

When introducing elements of the present disclosure or exemplary aspects or implementation(s) thereof, the articles "a," "an," "the" and "said" are intended to mean that there are one or more of the elements.

The terms "comprising," "including" and "having" are intended to be inclusive and mean that there may be additional elements other than the listed elements.

## Claims

1. A modular processing system, comprising:
a common transfer chamber body (222) defining a transfer volume (224);
a first vertical chamber body (240) defining a first processing volume (244) and positioned on the common transfer chamber body (222), wherein the transfer volume (224) is in fluid communication with the first processing volume (244);
a second vertical chamber body (240) defining a second processing volume (244) and positioned on the common transfer chamber body (222), wherein the transfer volume (224) is in fluid communication with the second processing volume (244); and
a reel-to-reel system operable to transport a continuous flexible substrate (230) having an electrode structure (140, 170) formed thereon, wherein the continuous flexible substrate (230) extends from the transfer volume (224), through the first processing volume (244), returning to the transfer volume (224), through the second processing volume (244), and returning to the transfer volume (224);
the modular processing system further comprising
a first deposition unit (252) installed in the first processing volume (244) and positioned vertically to be parallel to a movement direction of the continuous flexible substrate (230);
a second deposition unit (252) installed in the first processing volume (244) opposite the first deposition unit (252) and disposed vertically to be parallel to a movement direction of the continuous flexible substrate (230); and
a cooling plate (254) positioned in between the first deposition unit (252) and the second deposition unit (252); or
a third deposition unit (352) positioned in between the first deposition unit (252) and the second deposition unit (252).

2. The modular processing system of claim 1, wherein the reel-to-reel system further comprises an unwinding reel (262) for delivering the continuous flexible substrate (230) wound thereon to the transfer volume (224).

3. The modular processing system of claim 2, wherein the reel-to-reel system further comprises a winding reel (264) operable to accept and wind the surface-processed continuous flexible substrate (230) from the transfer volume (224).

4. The modular processing system of claim 3, wherein the continuous flexible substrate (230) extends from the unwinding reel (262), through the transfer volume (224), through the first processing volume (244), returning to the transfer volume (224), through the second processing volume (244), returning to the transfer volume (224), and to the winding reel (264).

5. The modular processing system of claim 1, further comprising a first tension reel (266) positioned in the transfer volume (224) and operable to divert the continuous flexible substrate (230) from a horizontal orientation to a vertical orientation.

6. The modular processing system of claim 1, further comprising a first partition plate (242) extending across the first vertical chamber body (240) dividing the first vertical chamber body (240) into the first processing volume (244) and a first turnaround volume.

7. The modular processing system of claim 6, further comprising a first turnaround roller (248) positioned in the first turnaround volume and operable to divert a direction of the continuous flexible substrate (230) from a vertical upward movement to a vertical downward movement.

8. The modular processing system of claim 7, wherein the first turnaround roller (248) is temperature-controlled.

9. A method (400) of forming a pre-lithiated electrode on a flexible substrate, comprising:
transporting (420) a continuous flexible substrate (230) into a first processing region of a first vertical processing module, wherein the continuous flexible substrate (230) comprises an electrode structure (140, 170);
exposing (430) the continuous flexible substrate (230) to a free-span pre-lithiation process while transporting the continuous flexible substrate (230) through the first processing region;
transporting (440, 450) the continuous flexible substrate (230) out of the first processing region through a common transfer volume (224) and into a second processing region of a second vertical processing chamber; and
exposing (460) the continuous flexible substrate (230) to a free-span passivation process while transporting the continuous flexible substrate (230) through the second processing region;
wherein
a first deposition unit (252) installed in the first processing region and positioned vertically to be parallel to a movement direction of the continuous flexible substrate (230);
a second deposition unit (252) installed in the first processing region opposite the first deposition unit and disposed vertically to be parallel to a movement direction of the continuous flexible substrate (230); and
a cooling plate positioned in between the first deposition unit and the second deposition unit (252); or
a third deposition unit (352) positioned in between the first deposition unit (252) and the second deposition unit (252).

10. The method of claim 9, further comprising transporting the continuous flexible substrate (230) out of the second processing region through the common transfer volume (224).

11. The method of claim 10, wherein the common transfer volume (224) comprises an inert gas atmosphere.

12. The modular processing system of claim 1, further comprising a third vertical chamber body (240) defining a third processing volume (244) and positioned on the common transfer chamber body (222), the transfer volume (224) in fluid communication with the third processing volume (244).

13. The modular processing system of claim 1, wherein the reel-to-reel system comprises:
an unwinding reel (262), on which the continuous flexible substrate (230) is wound prior to processing, and operable to unwind and release the continuous flexible substrate (230) for processing;
a winding reel (264) operable to receive the continuous flexible substrate (230) following processing, and operable to wind the continuous flexible substrate (230) thereon; and
a plurality of auxiliary tension reels (266), located on a path between the unwinding reel (262) and the winding reel (264) operable to guide the continuous flexible substrate (230).

## Patentansprüche

1. Modulares Prozesssystem, umfassend:
einen gemeinsamen Transferkammerkörper (222), der ein Transfervolumen (224) definiert;
einen ersten vertikalen Kammerkörper (240), der ein erstes Prozessvolumen (244) definiert und auf dem gemeinsamen Transferkammerkörper (222) positioniert ist, wobei das Transfervolumen (224) in Fluidverbindung mit dem ersten Prozessvolumen (244) steht;
einen zweiten vertikalen Kammerkörper (240), der ein zweites Prozessvolumen (244) definiert und auf dem gemeinsamen Transferkammerkörper (222) positioniert ist, wobei das Transfervolumen (224) in Fluidverbindung mit dem zweiten Prozessvolumen (244) steht; und
einem Rolle-zu-Rolle-System, das zum Transportieren eines kontinuierlichen flexiblen Substrats (230) mit einer darauf ausgebildeten Elektrodenstruktur (140, 170) betreibbar ist, wobei sich das kontinuierliche flexible Substrat (230) von dem Transfervolumen (224), durch das erste Prozessvolumen (244), zurück zu dem Transfervolumen (224), durch das zweiten Prozessvolumen (244), und zurück zum Transfervolumen (224) erstreckt;
wobei das modulare Prozesssystem ferner umfasst
eine erste Abscheideeinheit (252), die im ersten Prozessvolumen (244) installiert und vertikal parallel zu einer Bewegungsrichtung des kontinuierlichen flexiblen Substrats (230) positioniert ist;
eine zweite Abscheideeinheit (252), die in dem ersten Prozessvolumen (244) gegenüber der ersten Abscheideeinheit (252) installiert und vertikal parallel zu einer Bewegungsrichtung des kontinuierlichen flexiblen Substrats (230) angeordnet ist; und
eine Kühlplatte (254), die zwischen der ersten Abscheideeinheit (252) und der zweiten Abscheideeinheit (252) positioniert ist; oder
eine dritte Abscheideeinheit (352), die zwischen der ersten Abscheideeinheit (252) und der zweiten Abscheideeinheit (252) angeordnet ist.

2. Modulares Prozesssystem nach Anspruch 1, wobei das Rolle-zu-Rolle-System ferner eine Abwickelrolle (262) zum Zuführen des darauf gewickelten kontinuierlichen flexiblen Substrats (230) zum Transfervolumen (224) umfasst.

3. Modulares Prozesssystem nach Anspruch 2, wobei das Rolle-zu-Rolle-System ferner eine Aufwickelrolle (264) umfasst, die betätigbar ist, um das oberflächenverarbeitete kontinuierliche flexible Substrat (230) aus dem Transfervolumen (224) aufzunehmen und aufzuwickeln.

4. Modulares Prozesssystem nach Anspruch 3, wobei sich das kontinuierliche flexible Substrat (230) von der Abwickelrolle (262), durch das Transfervolumen (224), durch das erste Prozessvolumen (244), zurück zum Transfervolumen (224), durch das zweite Prozessvolumen (244), zurück zum Transfervolumen (224), und zur Aufwickelrolle (264) erstreckt.

5. Modulares Prozesssystem nach Anspruch 1, das ferner eine erste Spannrolle (266) umfasst, die im Transfervolumen (224) positioniert ist und betätigt werden kann, um das kontinuierliche flexible Substrat (230) aus einer horizontalen Ausrichtung in eine vertikale Ausrichtung umzulenken.

6. Modulares Prozesssystem nach Anspruch 1, ferner umfassend eine erste Trennplatte (242), die sich über den ersten vertikalen Kammerkörper (240) erstreckt und den ersten vertikalen Kammerkörper (240) in das erste Prozessvolumen (244) und ein erstes Umkehrvolumen unterteilt.

7. Modulares Prozesssystem nach Anspruch 6, das ferner eine erste Umkehrrolle (248) umfasst, die in dem ersten Umkehrvolumen positioniert ist und betätigbar ist, um eine Richtung des kontinuierlichen flexiblen Substrats (230) von einer vertikalen Aufwärtsbewegung in eine vertikale Abwärtsbewegung umzulenken.

8. Modulares Prozesssystem nach Anspruch 7, wobei die erste Umkehrrolle (248) temperaturgeregelt ist.

9. Verfahren (400) zum Ausbilden einer vorlithiierten Elektrode auf einem flexiblen Substrat, umfassend:
Transportieren (420) eines kontinuierlichen flexiblen Substrats (230) in einen ersten Prozessbereich eines ersten vertikalen Prozessmoduls, wobei das kontinuierliche flexible Substrat (230) eine Elektrodenstruktur (140, 170) umfasst;
Aussetzen (430) des kontinuierlichen flexiblen Substrats (230) einem Freispann-Vorlithiierungsprozess, während das kontinuierliche flexible Substrat (230) durch den ersten Prozessbereich transportiert wird;
Transportieren (440, 450) des kontinuierlichen flexiblen Substrats (230) aus dem ersten Prozessbereich durch einen gemeinsamen Transferraum (224) und in einen zweiten Prozessbereich einer zweiten vertikalen Prozesskammer; und
Aussetzen (460) des kontinuierlichen flexiblen Substrats (230) einem Freispann-Passivierungsprozess, während das kontinuierliche flexible Substrat (230) durch den zweiten Prozessbereich transportiert wird;
wobei
eine erste Abscheideeinheit (252) in dem ersten Prozessbereich installiert und vertikal parallel zu einer Bewegungsrichtung des kontinuierlichen flexiblen Substrats (230) positioniert ist;
eine zweite Abscheideeinheit (252), die in dem ersten Prozessbereich gegenüber der ersten Abscheideeinheit installiert und vertikal angeordnet ist, um parallel zu einer Bewegungsrichtung des kontinuierlichen flexiblen Substrats (230) zu sein; und
eine Kühlplatte, die zwischen der ersten Abscheideeinheit und der zweiten Abscheideeinheit (252) positioniert ist; oder
eine dritte Abscheideeinheit (352), die zwischen der ersten Abscheideeinheit (252) und der zweiten Abscheideeinheit (252) positioniert ist.

10. Verfahren nach Anspruch 9, das ferner das Transportieren des kontinuierlichen flexiblen Substrats (230) aus dem zweiten Prozessbereich durch das gemeinsame Transferrvolumen (224) umfasst.

11. Verfahren nach Anspruch 10, wobei das gemeinsame Transfervolumen (224) eine Inertgasatmosphäre umfasst.

12. Modulares Prozesssystem nach Anspruch 1, das ferner einen dritten vertikalen Kammerkörper (240) umfasst, der ein drittes Prozessvolumen (244) definiert und auf dem gemeinsamen Transferkammerkörper (222) positioniert ist, wobei das Transfervolumen (224) in Fluidverbindung mit dem dritten Prozessvolumen (244) steht.

13. Modulares Prozesssystem nach Anspruch 1, wobei das Rolle-zu-Rolle-System umfasst:
eine Abwickelrolle (262), auf die das kontinuierliche flexible Substrat (230) vor der Verarbeitung aufgewickelt wird und die betätigt werden kann, um das kontinuierliche flexible Substrat (230) zur Verarbeitung abzuwickeln und freizugeben;
eine Aufwickelrolle (264), die betätigt werden kann, um das kontinuierliche flexible Substrat (230) nach der Verarbeitung aufzunehmen, und die betätigt werden kann, um das kontinuierliche flexible Substrat (230) darauf aufzuwickeln; und
eine Vielzahl von Hilfs-Spannrollen (266), die auf einem Weg zwischen der Abwickelrolle (262) und der Aufwickelrolle (264) angeordnet sind und betätigbar sind, um das kontinuierliche flexible Substrat (230) zu führen.

## Revendications

1. Système de traitement modulaire comprenant :
un corps de chambre de transfert commun (222) définissant un volume de transfert (224) ;
un premier corps de chambre verticale (240) définissant un premier volume de traitement (244) et positionné sur le corps de chambre de transfert commun (222), dans lequel le volume de transfert (224) est en communication fluidique avec le premier volume de traitement (244) ;
un deuxième corps de chambre verticale (240) définissant un deuxième volume de traitement (244) et positionné sur le corps de chambre de transfert commun (222), dans lequel le volume de transfert (224) est en communication fluidique avec le deuxième volume de traitement (244) ; et
un système de bobine à bobine apte à transporter un substrat souple continu (230) sur lequel est formée une structure d'électrode (140, 170), dans lequel le substrat souple continu (230) s'étend à partir du volume de transfert (224), à travers le premier volume de traitement (244), revenant au volume de transfert (224), à travers le deuxième volume de traitement (244), et revenant au volume de transfert (224) ;
le système de traitement modulaire comprenant en outre
une première unité de dépôt (252) installée dans le premier volume de traitement (244) et positionnée verticalement de façon à être parallèle à une direction de déplacement du substrat souple continu (230) ;
une deuxième unité de dépôt (252) installée dans le premier volume de traitement (244) en regard de la première unité de dépôt (252) et disposée verticalement de façon à être parallèle à une direction de déplacement du substrat souple continu (230) ; et
une plaque de refroidissement (254) positionnée entre la première unité de dépôt (252) et la deuxième unité de dépôt (252) ; ou
une troisième unité de dépôt (352) positionnée entre la première unité de dépôt (252) et la deuxième unité de dépôt (252).

2. Système de traitement modulaire selon la revendication 1, dans lequel le système de bobine à bobine comprend en outre une bobine de déroulement (262) pour acheminer le substrat souple continu (230) enroulé sur celle-ci vers le volume de transfert (224).

3. Système de traitement modulaire selon la revendication 2, dans lequel le système de bobine à bobine comprend en outre une bobine d'enroulement (264) apte à accepter et enrouler le substrat souple continu traité en surface (230) en provenance du volume de transfert (224).

4. Système de traitement modulaire selon la revendication 3, dans lequel le substrat souple continu (230) s'étend à partir de la bobine de déroulement (262), à travers le volume de transfert (224), à travers le premier volume de traitement (244), retournant au volume de transfert (224), à travers le deuxième volume de traitement (244), retournant au volume de transfert (224), et jusqu'à la bobine d'enroulement (264).

5. Système de traitement modulaire selon la revendication 1 comprenant en outre une première bobine de tension (266) positionnée dans le volume de transfert (224) et apte à dévier le substrat souple continu (230) d'une orientation horizontale à une orientation verticale.

6. Système de traitement modulaire selon la revendication 1, comprenant en outre une première plaque de cloisonnement (242) s'étendant en travers du premier corps de chambre verticale (240) divisant le premier corps de chambre verticale (240) en un premier volume de traitement (244) et un premier volume de retournement.

7. Système de traitement modulaire selon la revendication 6, comprenant en outre un premier rouleau de retournement (248) positionné dans le premier volume de retournement et apte à dévier une direction du substrat souple continu (230) d'un déplacement vertical vers le haut en un déplacement vertical vers le bas.

8. Système de traitement modulaire selon la revendication 7, dans lequel le premier rouleau de retournement (248) est régulé en température.

9. Procédé (400) de formation d'une électrode pré-lithiée sur un substrat souple, comprenant :
le transport (420) d'un substrat souple continu (230) dans une première région de traitement d'un premier module de traitement vertical, dans lequel le substrat souple continu (230) comprend une structure d'électrode (140, 170) ;
l'exposition (430) du substrat souple continu (230) à un processus de pré-lithiation à portée libre tout en transportant le substrat souple continu (230) à travers la première région de traitement ;
le transport (440, 450) du substrat souple continu (230) hors de la première région de traitement à travers un volume de transfert commun (224) et dans une deuxième région de traitement d'une deuxième chambre de traitement verticale ; et
l'exposition (460) du substrat souple continu (230) à un processus de passivation à portée libre tout en transportant le substrat souple continu (230) à travers la deuxième région de traitement ;
dans lequel
une première unité de dépôt (252) installée dans la première région de traitement et positionnée verticalement de façon à être parallèle à une direction de déplacement du substrat souple continu (230) ;
une deuxième unité de dépôt (252) installée dans la première région de traitement en regard de la première unité de dépôt et disposée verticalement de façon à être parallèle à une direction de déplacement du substrat souple continu (230) ; et
une plaque de refroidissement positionnée entre la première unité de dépôt et la deuxième unité de dépôt (252) ; ou
une troisième unité de dépôt (352) positionnée entre la première unité de dépôt (252) et la deuxième unité de dépôt (252).

10. Procédé selon la revendication 9, comprenant en outre le transport du substrat souple continu (230) hors de la deuxième région de traitement à travers le volume de transfert commun (224).

11. Procédé selon la revendication 10, dans lequel le volume de transfert commun (224) comprend une atmosphère de gaz inerte.

12. Système de traitement modulaire selon la revendication 1, comprenant en outre un troisième corps de chambre verticale (240) définissant un troisième volume de traitement (244) et positionné sur le corps de chambre de transfert commun (222), le volume de transfert (224) étant en communication fluidique avec le troisième volume de traitement (244).

13. Système de traitement modulaire selon la revendication 1, dans lequel le système de bobine à bobine comprend :
une bobine de déroulement (262), sur laquelle le substrat souple continu (230) est enroulé préalablement au traitement, et apte à dérouler et libérer le substrat souple continu (230) pour traitement ;
une bobine d'enroulement (264) apte à recevoir le substrat souple continu (230) après traitement, et apte à enrouler le substrat souple continu (230) sur celle-ci ; et
une pluralité de bobines de tension auxiliaires (266), situées sur un chemin entre la bobine de déroulement (262) et la bobine d'enroulement (264), apte à guider le substrat souple continu (230).
